Europäisches Patentamt

European Patent Office

Office européen des brevets

(11) Publication number: **0 055 114**
**B1**

## EUROPEAN PATENT SPECIFICATION

(45) Date of publication of patent specification: **19.08.87**

(51) Int. Cl.⁴: **H 01 L 27/14**

(21) Application number: **81305996.1**

(22) Date of filing: **21.12.81**

(54) Solid-state imaging device.

(30) Priority: **24.12.80 JP 184784/80 u**

(43) Date of publication of application:
**30.06.82 Bulletin 82/26**

(45) Publication of the grant of the patent:
**19.08.87 Bulletin 87/34**

(84) Designated Contracting States:
**DE FR GB**

(56) References cited:
**US-A-4 346 395**

**PATENTS ABSTRACTS OF JAPAN, vol. 3, no.
52 (E-108), 7th May 1979, page 99 E 108**

**IEEE TRANSACTIONS ON ELECTRON
DEVICES, vol. ED-27, no. 8, August 1980, pages
1682-1687, IEEE, New York, US S. OHBA et al.:
"MOS area sensor: Part II - Low noise MOS area
sensor with antiblooming photodiodes"**

**IEEE JOURNAL OF SOLID-STATE CIRCUITS,
vol. SC-13, no. 4, August 1978, pages 468-71,
IEEE, New York, US J. SAKURAI: "A new
buried-oxide isolation for high-speed high-
density MOS integrated circuits"**

(73) Proprietor: **Hitachi, Ltd.**
**5-1, Marunouchi 1-chome**
**Chiyoda-ku Tokyo 100 (JP)**

(72) Inventor: **Takemoto, Iwao**
**2196-458, Hirai Hinodemachi**
**Nishitama-gun Tokyo (JP)**
Inventor: **Ohba, Shinya**
**3511-8, Kawashiri Shiroyama-cho**
**Tsuki-gun Kanagawa-ken (JP)**
Inventor: **Aoki, Masakazu**
**1473-B5-1, Josuihoncho Kodaira-shi**
**Tokyo (JP)**
Inventor: **Ando, Harushisa**
**2-32-A403, Koyasu-cho Hachioji-shi**
**Tokyo (JP)**
Inventor: **Nakai, Masaaki**
**1473, Josuihoncho Kodaira-shi**
**Tokyo (JP)**
Inventor: **Ozaki, Toshifumi**
**622-7, Ohizumigakuen-cho Nerima-ku**
**Tokyo (JP)**
Inventor: **Tamura, Masao**
**5-17-6, Nakaarai Tokorozawa-shi**
**Saitama-ken (JP)**
Inventor: **Miyao, Masanobu**
**1188-5-107, Kamiarai Tokorozawa-shi**
**Saitama-ken (JP)**

**0 055 114**

(58) References cited:
  IEEE ELECTRON DEVICE LETTERS, vol. EDL-1,
  no. 10, October 1980, pages 206-208, IEEE, New
  York, US H.W. LAM et al.: "Characteristics of
  MOSFETS fabricated in laser-recrystallized
  polysilicon islands with a retaining wall
  structure on an insulating substrate"

(74) Representative: **Paget, Hugh Charles Edward
  et al**
  **MEWBURN ELLIS & CO. 2/3 Cursitor Street
  London EC4A 1BQ (GB)**

## Description

This invention relates to a solid-state imaging device, e.g. for use in a television camera, and more particularly to the structure of a picture element thereof.

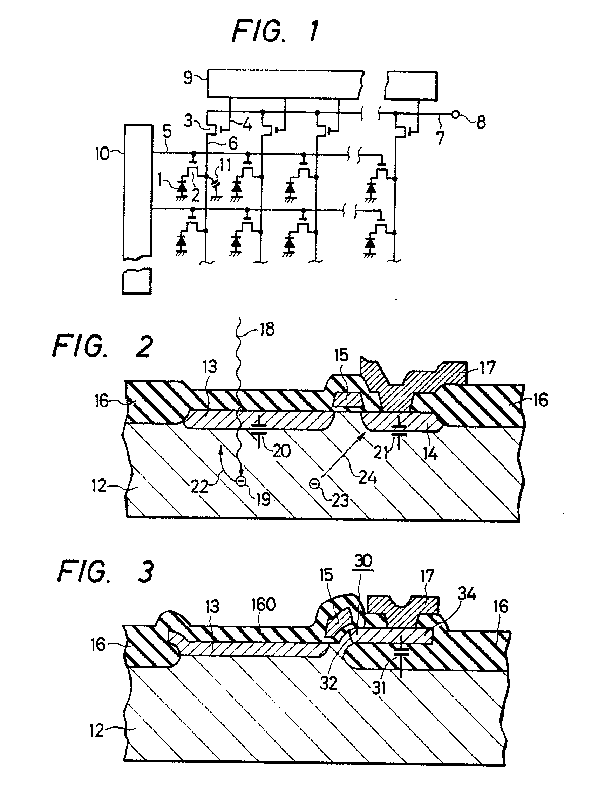

Figure 1 of the accompanying drawings is a schematic diagram showing the arrangement of a solid-state imaging device. A photoelectric conversion element made of a photodiode 1, and an insulated-gate field effect transistor (hereinbelow, abbreviated to "MOS transistor") 2 for a vertical scanning switch constitute one picture element. Using a horizontal scanning circuit 9 and also a vertical scanning circuit 10 made of a shift register and MOS transistors 3 for horizontal scanning switches, optical signals stored in the photodiodes 1 are sequentially led out to an output terminal 8 in conformity with the scanning type of television. The figure illustrates the basic form. Especially regarding the signal output system, various modifications are known, for example, the provision of a plurality of signal output lines 6 or 7 for simultaneously delivering color signals in color imaging, and the use of charge transfer devices in the scanning circuits. In addition, there is a modified vertical scanning system conforming with the interlaced scanning of television. Further, there is a modification pertaining to picture elements for improved photoelectric conversion characteristics as disclosed in U.S.—A—4148048. The ensuing description is similarly applicable to these modifications. While devices whose signal charges are electrons will be described, the ensuing description is quite similarly applicable to devices utilizing holes as their signal charges, merely by inverting the polarity and the conductivity types.

Figure 2 of the accompanying drawings is a schematic sectional view of a picture element. The problems of the prior art will be explained with reference to the figure.

A p-type Si substrate 12 and an n-type diffusion layer 13 form the photodiode 1, while the n-type diffusion layer 13, a gate electrode 15 made of polycrystalline Si or the like and an n-type diffusion layer 14 serving as an output terminal form the switching MOS transistor 2. A photoelectron 19 generated by the incidence of light 18 is stored in a junction capacitance 20, and a positive voltage pulse issued by the vertical scanning circuit 10 is impressed on the gate electrode 15, whereby the photoelectron is delivered through the n-type diffusion layer 14 every scanning period. Numeral 16 designates an insulating film made of $SiO_2$ or the like.

This picture element of the prior art has serious disadvantages in the following two points.

The first concerns noise charges. Some of the photoelectrons 23 generated within the Si substrate 12 form a component which does not flow into the n-type diffusion layer 13 but flows into the n-type diffusion layer 14 as shown by arrow 24. This component is superposed on the signal of other picture elements sharing the vertical signal output line 6 (a metal interconnection 17 in Figure 2) when the signal is read out. When imaging a bright object, therefore, a bright line or stripe appears in the vertical direction in the reproduced picture and spoils the picture quality (this phenomenon is called "smear"). This is the serious disadvantage which is common to solid-state imaging devices and on account of which they are much inferior to image pickup tubes.

The other disadvantage concerns parasitic capacitances. The n-type diffusion layer 14 has a junction capacitance 21 similar to the junction capacitance 20 of the photodiode. The vertical signal output line 6 connects in parallel such junction capacitances 21 of all the picture elements arrayed in the vertical direction (the number of such picture elements depends upon the signal readout system, and is about 250 or 500 in case of the NTSC standard format). The resultant parasitic capacitance 11 is very large. The parasitic capacitance forms a cause for the occurrence of thermal noise in which small photoelectric conversion signals are swamped. In effect, the sensitivity of the imaging device is drastically lowered.

A solid-state imaging device is known from US—A—4346395 in which a plurality of picture elements are arrayed on a semiconductor body in the form of a matrix. Each picture element consists of a photoelectric conversion element and a switching element. Scanning means is provided for sequentially scanning the picture elements and reading out photoelectric conversion signals. Thus this document corresponds to the precharacterising part of claim 1. In US—A—4346395 the switching element is a MOS transistor but, as mentioned in the document, the drain junction capacitance of the MOS transistor causes a decrease in level of the photoelectric conversion signal.

It is known from Patents Abstracts of Japan Vol. 3, No. 52 (E-108) 7th May, 1979, page 99E108, and JP—A—54-31238, to reduce the capacitance of the drain regions of MOS transistors in an array by means of an insulating layer between the drain region and the semiconductor substrate. However, it has now been realised that better results are obtained if the semiconductor region (the "first" region) which forms an output terminal of the switching element is totally isolated from the semiconductor body. This is achieved, according to the present invention as claimed by at least an insulating film overlying the semiconductor body and a second semiconductor region of opposite conductivity type to the first semiconductor region.

Preferably, the switching element is an insulated-gate field effect transistor which includes the first semiconductor region and at least a third semiconductor region, with the second semiconductor region between the first and third semiconductor regions, and the device has a gate electrode on a gate insulating film over the second semiconductor region.

Embodiments of the invention will now be described, by way of example, with reference to the accompanying drawings, in which:

Figure 1 is a schematic circuit diagram showing the arrangement of a solid-state imaging device;

Figure 2 is a sectional view showing the prior art structure of a picture element portion in the solid-state imaging device;

Figure 3 is a sectional view showing the structure of one arrangement of a picture element portion in a solid-state imaging device useful for understanding the fabrication of a device according to the present invention;

Figures 4A to 4D are sectional views showing the successive steps of an example of a process for manufacturing the picture element portion of Figure 3;

Figure 5 is a sectional view showing an embodiment of the structure of a picture element portion in a solid-state imaging device according to the present invention;

Figure 6 is a circuit diagram showing the equivalent circuit of the picture element portion in Figure 5;

Figure 7 is a sectional view showing another embodiment of the structure of a picture element portion in a solid-state imaging device according to the present invention;

Figure 8 is a circuit diagram showing the equivalent circuit of the picture element portion in Figure 7.

Figure 3 illustrates a solid-state imaging device which, although not possessing features of the present invention, is nevertheless helpful in understanding the present invention. The figure shows the sectional structure of a picture element portion. In the figure, numeral 12 designates an Si body of p-type conductivity (the expression "body" signifies an epitaxially grown layer formed on a substrate, a diffused well formed within a substrate, a substrate itself, etc.). Numeral 13 indicates an n-type conductivity region, numeral 15 a gate electrode (made of polycrystalline Si or the like), numeral 16 a thick insulating film (made of $SiO_2$ or the like) for isolating elements from each other, numeral 160 an insulating film (made of $SiO_2$ of the like), numeral 17 an interconnection layer (made of A1 or the like) for a vertical signal output line, and numeral 34 an n-type Si layer.

As illustrated in Figure 3, the n-type layer 34 serves as an output terminal and is formed on the insulating layer 16, typified by $SiO_2$ film, which is thick and is of low permittivity. In this structure, photoelectrons generated within the Si body 12 can only flow in through a narrow junction 32, and the flow is conspicuously limited. Further, under ordinary operating conditions, an electric field which drives electrons away acts under the gate electrode 15 during the time when there is no signal readout signal on the gate, so that there is substantially no photoelectron flow into the n-type layer 34. In addition, the parasitic capacitance 31 is remarkably lower owing to the low permittivity and great thickness of the insulating layer 16. As a result, smear is avoided, and a device of low noise and high sensitivity is fabricated.

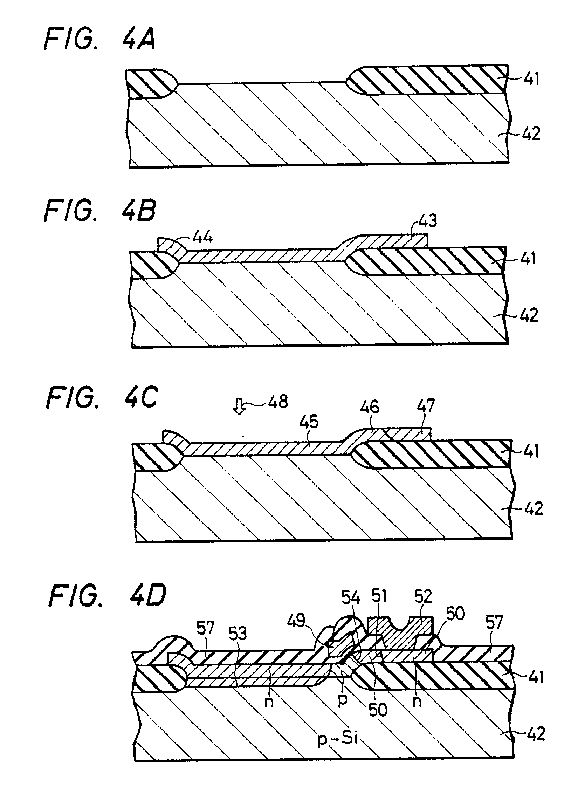

In order to attain good characteristics with little leakage current, the junction 32 should desirably lie within a single crystal layer continuous from the Si body 12. Although the whole n-type layer 34 need not be a single crystal, the present embodiment has on the insulating layer 16 a single crystal layer 30 which extends, at least, beyond the junction 32. Referring now to Figures 4A—4D, an example of a process for manufacturing the device of Fig. 3 will be described.

The device can be manufactured essentially by utilizing the ordinary Si-gate NMOS LSI technology. An $SiO_2$ film 41 which serves to isolate elements and which is approximately 1 μm thick is formed on a p-type Si body 42 by, for example, selective oxidation (Figure 4A). Subsequently, an amorphous or polycrystalline Si layer 43 which is approximately 0.5 μm thick is formed by such an expedient as sputtering, electron-beam evaporation and vapor growth, and the unnecessary parts of the Si layer are removed or selectively oxidized by the conventional photolithographic technology so as to leave a necessary extension on the $SiO_2$ film 41 (Figure 4B). If an extension 44 forming an end of a photodiode is not provided, there is no particular problem. In forming the Si layer 43, an impurity for turning it into the p-conductivity type, such as B (boron), may well be mixed in a very small amount.

Now, let it be supposed that the Si layer 43 is polycrystalline. When it is scanned with, for example, a CW laser beam 48 of Ar at 12 W at a speed of about 50 cm/sec., and Si layer 45 lying in contact with the p-type Si body 42 turns into a single crystal and a single crystal layer 46 extending on the $SiO_2$ film is subsequently grown as explained in DE—A—3043913 (Figure 4C). While the amount of extension of the single crystal layer 46 depends upon the heating condition and time, the purpose can be substantially achieved with an amount of at least 2 μm. Of course, the remaining polycrystalline layer 47 may well be entirely turned into a single crystal. The heating temperature is not restricted to a value of or above the melting point (~1400°C) of Si, but the solid phase single-crystal growth proceeds even at a temperature below the melting point, for example, a temperature of approximately 1100°C. In addition, a similar effect can be attained with another heating method, for example, heating with a pulse laser beam, an electron beam or by the conventional electric furnace.

Thereafter, quite similarly to the prior art, there are formed an $SiO_2$ film 57, a gate electrode 49 made of polycrystalline Si, n-type diffusion layers 50 and 53, and a vertical signal output line 52 made of A1, thus to obtain the intended device (Figure 4D). Insofar as the interface 51 between the single-crystal Si and the polycrystalline Si is included in the n-type diffusion layer 50 (a p-n junction being indicated at 54), most of the n-type diffusion layer 50 may be of the polycrystalline Si.

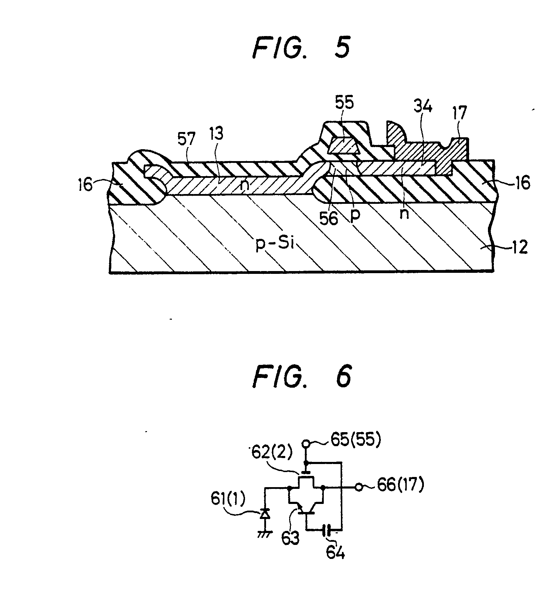

An embodiment of this invention is shown in Figure 5. Unlike the arrangement shown in Figure 3, a region 56 underlying a gate electrode 55 is also formed on the single-crystal Si layer extending on the insulating film 16. In this case, photoelectrons generated in the Si body 12 are perfectly isolated from the n-type layer 34. Owing to the presence of the p-type region 56 spaced from the Si body 12, the equivalent circuit of the picture element has a parasitic bipolar transistor 63 (13-56-34) and a gate capacitance 64 added as illustrated in Figure 6. This, however, is solely contributive to enhancing the switching speed and does not bring about any undesirable effects as are observed in an SOS (Silicon On Sapphire) device. Even if the vertical signal output line 17 is formed so as to protrude beyond the n-type layer 34 as illustrated in Figure 5, the characteristics of the device are not affected because the underlying layer is the insulating film 16 in contrast to the case of the prior art. This is also effective to remarkably loosen the alignment tolerance between the layers and to facilitate the processing.

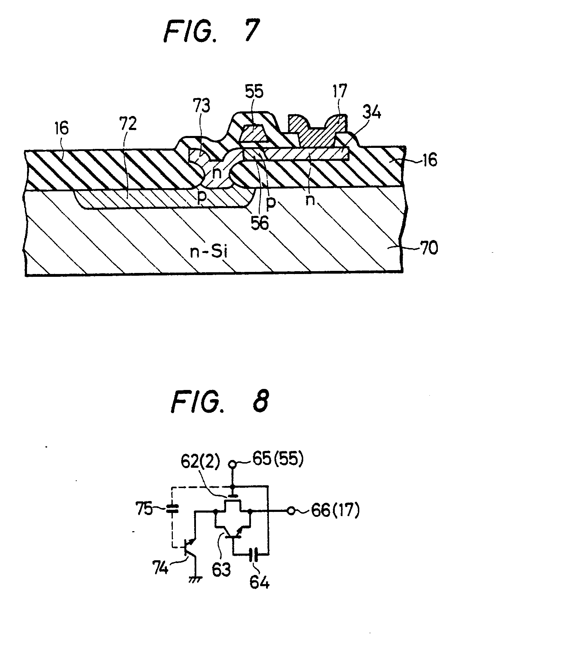

Another embodiment of this invention is shown in Figure 7. It is fabricated by employing an n-type Si body 70 instead of the p-type Si body and forming a p-type diffusion layer 72 by the conventional selective diffusion method before the selective oxidization in Figure 4A. As illustrated by the equivalent circuit of the picture element in Figure 8, the photodiode is changed to a p-n-p bipolar type phototransistor 74 (72-73-56), and a device of sharply enhanced sensitivity having an amplifier within the picture element is realized. In spite of having this phototransistor, the manufacturing method is remarkably simplified. This solid-state imaging device as claimed in claims 5—8 is structurally suited to a high density of integration (similarly to the case of the photodiode), and exhibits a high sensitivity as well as a high resolution. An improvement is possible in which a p-type body is used and an n-type diffusion layer is further disposed under the p-type diffusion layer 72 so as to attain a nearly ideal spectral sensitivity. Another improvement is to add a coupling capacitance 75 (Figure 8) between the gate electrode 55 and the p-type diffusion layer 72 so as to improve the readout of small signals. Either of these improvements can be adopted without spoiling the effect at all.

As set forth above, an imaging device which is free from smear and which has a high sensitivity can be readily realized.

## Claims

1. A solid-state imaging device wherein a plurality of picture elements each consisting of a photoelectric conversion element (1) and a switching element (2) are arrayed on a semiconductor body (12, 70) in the form of a matrix and wherein scanning means (9, 10) is provided for sequentially scanning the picture elements and sequentially reading out photoelectric conversion signals; characterised in that: at least a first semiconductor region (34) serving as an output terminal of each switching element (2) is totally isolated from the semiconductor body (12, 70) by at least an insulating film (16) overlying the semiconductor body (12, 70), the first semiconductor region being disposed on said insulating film, and a second semiconductor region (56) of opposite conductivity type to and adjoining the first semiconductor region (34).

2. A device according to claim 1, wherein the switching element (2) is an insulated-gate field effect transistor which includes the first semiconductor region (34) and at least a third semiconductor region (13, 73), with the second semiconductor region (56) between the first and third semi-conductor regions (34, 13, 73), and the device has a gate electrode (55) on a gate insulating film over the second semiconductor region (56).

3. A device according to claim 2, wherein the semiconductor body (12) and the second semiconductor region are of a first conductivity type, the first and third semiconductor regions (34, 13) are of a second conductivity type opposite to the first conductivity type, whereby a photodiode is formed by the third semiconductor region (13) and the semiconductor body (12).

4. A device according to claim 3, wherein the second semiconductor region (56) is also disposed on the insulating film (16).

5. A solid-state imaging device according to claim 1 or 2, wherein the photoelectric conversion element is a bipolar phototransistor (74) formed by the second semiconductor region (56), the third semiconductor region (73) and a fourth semiconductor region (72) disposed between the third semiconductor region (73) and the semiconductor body (70), wherein at least the first semiconductor region (34) is in a semiconductor layer, at least a part of which is on the insulating film (16).

6. A device according to claim 5, wherein the semiconductor layer (73, 56, 34) is a single-crystal layer which extends from a surface of the semiconductor body (12) to a surface of the insulating film (16).

7. A device according to claim 6, wherein the semiconductor layer (73, 56, 34) is a single-crystal layer (45, 46) which extends from a surface of the semiconductor body (12) to a surface of the insulating film (16), together with a polycrystalline or amorphous layer (47) which is disposed on the insulating film (16) so as to couple with the single-crystal layer (47).

8. A device according to claim 5, wherein the semiconductor body (70) and the first and third semiconductor regions (34, 73) are of a first conductivity type, and the second (56) and fourth (72) semiconductor regions are of a second conductivity type opposite to the first conductivity type.

## Patentansprüche

1. Festkörper-Bildaufnahmevorrichtung, bei der eine Anzahl von Bildelementen, von denen jede aus einem photoelektrischen Unwandlungselement (1) und einem Schaltelement (2) besteht, auf einem Halbleiterkörper (12, 70) in Form einer Matrix angeordnet sind und bei der eine Abtastvorrichtung (9, 10) zum sequentiellen Abtasten der Bildelemente und zum sequentiellen Auslesen der photoelektrischen Konversionssignale vorgesehen sind, dadurch gekennzeichnet, daß wenigstens ein erstes Halbleitergebiet (34), das als Ausgangsanschluß für jedes Schaltelement (2) dient, von dem Halbleiterkörper (12, 70) durch wenigstens einen Isolationsfilm (16), der über dem Halbleiterkörper (12, 70) liegt, wobei das erste Halbleitergebiet auf dem Isolationsfilm angeordnet ist, und durch ein zweites Halbleitergebiet (56) mit entgegengesetztem Leitungstyp, das an das erste Halbleitergebiet (34) angrenzt, vollständig isoliert ist.

2. Vorrichtung nach Anspruch 1, bei der das Schaltelement (2) ein Feldeffekttransistor mit isoliertem Gate ist, der das erste Halbleitergebiet (34) und wenigstens ein drittes Halbleitergebiet (13, 73) umfaßt, wobei das zweite Halbleitergebiet (56) sich zwischen dem ersten und dem dritten Halbleitergebiet (34; 13, 73) befindet und die Vorrichtung eine Gate-Elektrode (55) auf dem Gate-Isolationsfilm über dem zweiten Halbleitergebiet (56) besitzt.

3. Vorrichtung nach Anspruch 2, bei der der Halbleiterkörper (12) und das zweite Halbleitergebiet den ersten Leitungstyp aufweisen, das erste und das dritte Halbleitergebiet (34, 13) den dem ersten Leitungstyp entgegengesetzten zweiten Leitungstyp besitzen, wodurch eine Photodiode mit dem dritten Halbleitergebiet (13) und dem Halbleiterkörper (12) gebildet wird.

4. Vorrichtung nach Anspruch 3, bei der das Halbleitergebiet (56) auch auf dem Isolationsfilm (16) angeordnet ist.

5. Festkörperbildaufnahmevorrichtung nach Anspruch 1 oder 2, bei der das photoelektrische Konversionselement ein bipolarer Transistor (74) ist, der mit dem zweiten Halbleitergebiet (56), dem dritten Halbleitergebiet (73) und einem vierten Halbleitergebiet (72), welches zwischen dem dritten Halbleitergebiet (73) und dem Halbleiterkörper (70) angeordnet ist, gebildet wird, wobei wenigstens das erste Halbleitergebiet (34) sich in einer Halbleiterschicht befindet, von der wenigstens ein Teil auf dem Isolationsfilm (16) angeordnet ist.

6. Vorrichtung nach Anspruch 5, bei der die Halbleiterschicht (73, 56, 34) eine einkristalline Schicht ist, die sich von der Oberfläche des Halbleiterkörpers (12) zu der Oberfläche des Isolationsfilmes (16) erstreckt.

7. Vorrichtung nach Anspruch 6, bei der die Halbleiterschicht (73, 56, 34) eine einkristalline Schicht (45, 46) ist, die sich von der Oberfläche des Halbleiterkörpers (12) zur Oberfläche des Isolationsfilms (16) erstreckt, zusammen mit einer polykristallinen oder amorphen Schicht (47), die auf dem Isolationsfilm (16) angeordnet ist, so daß sie mit der einkristallinen Schicht (45, 46) verbunden ist.

8. Vorrichtung nach Anspruch 5, bei der der Halbleiterkörper (70) und das erste und das dritte Halbleitergebiet (34, 73) den ersten Leitungstyp aufweisen, und das zweite (56) und das vierte (72) Halbleitergebiet den zweiten Leitungstyp besitzen, der entgegengesetzt zu dem ersten Leitungstyp ist.

**Revendications**

1. Dispositif de formation d'images à l'état solide, dans lequel une pluralité d'éléments d'image, constitués chacun par un élément de conversion photoélectrique (1) et un élément de commutation (2), sont disposés en réseau sous la forme d'une matrice sur un corps semiconducteur (12, 70), et dans lequel des moyens d'exploration par balayage (9, 10) sont prévus pour réaliser l'exploration séquentielle par balayage des éléments d'image et la lecture séquentielle des signaux de conversion photo-électriques; caractérisé en ce que:
— au moins une première région semiconductrice (34) servant de borne de sortie de chaque élément de commutation (2) est totalement isolée par rapport au corps semiconducteur (12, 70), par au moins une pellicule isolante (16) recouvrant le corps semiconducteur (12, 70), la première région semiconductrice étant disposée sur ladite pellicule isolante, et une seconde région semiconductrice (56) possédant le type de conductivité opposé à celui de la première région semiconductrice (34) et jouxtant cette dernière.

2. Dispositif selon la revendication 1, dans lequel l'élément de commutation (2) est un transistor à effet de champ à grille isolée, qui inclut la première région semiconductrice (34) et au moins une troisième région semiconductrice (13, 73), la seconde région semiconductrice (56) étant située entre les première et troisième régions semiconductrices (34, 13, 73), et le dispositif comporte une électrode de grille (55) située sur une pelliculée d'isolant de grille située sur la seconde région semiconductrice (56).

3. Dispositif selon la revendication 2, dans lequel le corps semiconducteur (12) et la seconde région semiconductrice possèdent un premier type de conductivité, et les première et troisième régions semiconductrices (34, 13) possèdent un second type de conductivité opposé au premier type de conductivité, ce qui a pour effet qu'une photodiode est formée par la troisième région semiconductrice (13) et le corps semiconducteur (12).

4. Dispositif selon la revendication 3, dans lequel la seconde région semiconductrice (56) est également disposée sur la pellicule isolante (16).

5. Dispositif de formation d'images à l'état solide selon la revendication 1 ou 2, dans lequel l'élément de conversion photoélectrique est un phototransistor bipolaire (74) formé par la seconde région semiconductrice (56), la troisième région semiconductrice (73) et une quatrième région semiconductrice (72) disposée entre la troisième région semiconductrice (73) et le corps semiconducteur (70), et dans lequel au moins la première région semiconductrice (34) est une couche semiconductrice, dont au moins une partie est située sur la pellicule isolante (16).

6. Dispositif selon la revendication 5, dans lequel la couche semiconductrice (73, 56, 34) est une couche monocristalline, qui s'étend depuis une surface du corps semiconducteur (12) jusqu'à une surface de la pellicule isolante (16).

7. Dispositif selon la revendication 6, dans lequel la couche semiconductrice (73, 56, 34) est une couche monocristalline (45, 46), qui s'étend à partir d'une surface du corps semiconducteur (12) jusqu'à une surface de la pellicule isolante (16), de concert avec une couche polycristalline ou amorphe (47), qui est disposée sur la pellicule isolante (16) de manière à être accouplée à la couche monocristalline (47).

8. Dispositif selon la revendication 5, dans lequel le corps semiconducteur (70) et les première et troisième régions semiconductrices (34, 73) possèdent un premier type de conductivité, et la seconde région semiconductrice (56) et la quatrième région semiconductrice (72) possèdent un second type de conductivité opposé au premier type de conductivité.

*FIG. 1*

*FIG. 2*

*FIG. 3*

## FIG. 4A

41
42

## FIG. 4B

44
43
41
42

## FIG. 4C

48
45
46
47
41
42

## FIG. 4D

57 53
49
54 51
52
50
57
41
n
p
50
n
p-Si
42

## FIG. 5

## FIG. 6

## FIG. 7

## FIG. 8